# EUROPÄISCHE PATENTSCHRIFT

(11) **EP 3 317 965 B1**
(45) Veröffentlichungstag und Bekanntmachung des Hinweises auf die Patenterteilung: **14.10.2020**
(21) Anmeldenummer: 16739431.1
(22) Anmeldetag: 30.06.2016
(51) Int. Cl.: H03F 3/193, H01J 37/32, H03F 3/217, H03F 3/30

(54) **NICHT LINEARE HOCHFREQUENZVERSTÄRKERANORDNUNG**
NON-LINEAR HIGH-FREQUENCY AMPLIFIER ARRANGEMENT
ENSEMBLE AMPLIFICATEUR HAUTE FRÉQUENCE NON LINÉAIRE

(30) Priorität: 30.06.2015 DE 102015212152
(43) Veröffentlichungstag der Anmeldung: 09.05.2018
(73) Patentinhaber: TRUMPF Hüttinger GmbH + Co. KG, 79111 Freiburg (DE)
(72) Erfinder: GREDE, André, 3018 Bern (CH); ALT, Alexander, Cardiff CF143UA (GB); GRUNER, Daniel, 79379 Muellheim (DE); LABANC, Anton, 79238 Ehrenkirchen (DE)
(74) Vertreter: Trumpf Patentabteilung
(86) Internationale Anmeldenummer: PCT/EP2016/065382
(87) Internationale Veröffentlichungsnummer: WO 2017/001599

(56) Entgegenhaltungen:
- DE-A1- 3 240 726
- JP-B2- 4 248 637
- JP-B2- 4 271 457
- US-A1- 2003 215 373
- US-A1- 2011 241 781
- US-A1- 2014 361 690

## Beschreibung

Die Erfindung betrifft eine nicht lineare Hochfrequenzverstärkeranordnung, die geeignet ist, Ausgangsleistungen ≥ 1 kW bei Frequenzen ≥ 1 MHz zur Plasmaanregung zu erzeugen, umfassend:
a. zwei LDMOS-Transistoren, die mit ihrem Sourceanschluss jeweils mit einem Masseverbindungspunkt verbunden sind, wobei die LDMOS-Transistoren gleichartig ausgebildet sind und in einer Baugruppe (Package) angeordnet sind,
b. einen Leistungsübertrager, dessen Primärwicklung mit den Drainanschlüssen der LDMOS-Transistoren verbunden ist,
c. einen Signalübertrager, dessen Sekundärwicklung mit einem ersten Ende mit dem Gateanschluss des einen LDMOS-Transistors verbunden ist und mit einem zweiten Ende mit dem Gateanschluss des anderen LDMOS-Transistors verbunden ist.

Unterschiedliche Verstärkeranordnungen werden z.B. in den folgenden Schriften gezeigt: US2014/0167858 A1, US2006/0158911 A1,
US6,157,258 A, US2002/0149425 A1, US6,046,641 A,
US2003/215373 A1, JP 4 271 457 B2.

LDMOS Transistoren sind beispielsweise aus der folgenden Schrift bekannt: Freescale Semiconductor, Technical Data, RF Power LDMOS Transistors, Document Number: MRFE6VP61K25H Rev. 4.1, 3/2014.

Nicht lineare Hochfrequenzverstärker werden unter anderem eingesetzt, um eine Leistung zu erzeugen, die geeignet ist, einen Plasmaprozess zu betreiben. LDMOS-Transistoren, insbesondere so genannte extrarugedness LDMOS Transistoren, sind wegen ihrer Robustheit gegen rückgespeiste Energie besonders geeignet, bei derartigen Verstärkern verwendet zu werden, insbesondere für Anwendungen mit fehlangepasster Last. Bei extremer Fehlanpassung könnte jedoch auch ein solcher Transistor aufschwingen und/oder schnell zerstört werden. Dabei kann es zu Selbstschwingungen wegen zu hoher Verstärkung bei einer bestimmten Last kommen. Außerdem kann ein zu schneller Spannungsanstieg einen parasitären Bipolarsransistor in der MOSFET-Struktur einschalten und dadurch den Transistor zerstören.

Aufgabe der vorliegenden Erfindung ist es, eine Hochfrequenzverstärkeranordnung bereitzustellen, die LDMOS-Transistoren aufweist und die eine möglichst große Stabilität bei unterschiedlichen Lastzuständen aufweist.

Gelöst wird diese Aufgabe erfindungsgemäß durch eine nicht lineare Hochfrequenzverstärkeranordnung, die geeignet ist, Ausgangsleistungen ≥ 1 kW bei Frequenzen ≥ 1 MHz zur Plasmaanregung zu erzeugen, umfassend:
a. zwei LDMOS-Transistoren, die mit ihren Sourceanschlüssen jeweils mit einem Masseverbindungspunkt verbunden sind, wobei die LDMOS-Transistoren gleichartig ausgebildet sind und in einer Baugruppe (Package) angeordnet sind,
b. einen Leistungsübertrager, dessen Primärwicklung mit den Drainanschlüssen der LDMOS-Transistoren verbunden ist,
c. einen Signalübertrager, dessen Sekundärwicklung mit einem ersten Ende mit dem Gateanschluss des einen LDMOS-Transistors und mit einem zweiten Ende mit dem Gateanschluss des anderen LDMOS-Transistors, insbesondere über einen Widerstand, verbunden ist,
d. jeweils einen Rückkoppelpfad von dem Drainanschluss zu dem Gateanschluss jedes LDMOS-Transistors und wobei
e. die Drainanschlüsse der LDMOS-Transistoren jeweils über zumindest einen Kondensator mit Masse verbunden sind.

Durch die Maßnahme gemäß Merkmal d) kann verhindert werden, dass die Hochfrequenzverstärkeranordnung zum ungewünschten Oszillator wird, wenn eine Schleife mit positiver Rückkopplung mit Koppelfaktor > 1 geschlossen wird. Eine solche Schleife könnte aufweisen: ein Eingangsnetzwerk, einen Transistor, ein Ausgangsnetzwerk inklusive Last und/oder Rückkopplungen. Für Kleinsignalverstärker gibt es verschiedene Kriterien, um die Stabilität zu bestimmen. Bei einem nicht linearen Leistungsverstärker sind diese nicht anzuwenden und man ist auf numerische Simulation - falls ein vernünftiges Modell vorhanden ist - oder Experiment angewiesen. Bei einem nicht linearen Hochfrequenzverstärker kann es zu zwei Arten der Selbstschwingung kommen. Es kann zu einer Selbstschwingung ohne Ansteuersignal (entweder ganz selbständig oder durch ein Ansteuersignal ausgelöst und eine Schwingung besteht auch nach dem Ausschalten des Ansteuersignals) kommen (erste Art der Selbstschwingung). Weiterhin wurden niederfrequente Signale beobachtet, die zum Teil nur einen Bruchteil der Arbeitsfrequenz, d.h. der Ansteuerfrequenz der Transistoren, aufweisen, die nur bei einer bestimmten Amplitude des Ansteuersignals erscheinen (zweite Art der Selbstschwingung). Bei der ersten Art der Selbstschwingung kann es sich um hohe Leistungen handeln, die den Verstärker gefährden. Bei der zweiten Art der Selbstschwingung kommt es zu Verunreinigungen des Ausgangssignals. Eine Stabilisierung lässt sich erfindungsgemäß dadurch erreichen, dass eine breitbandige Rückkopplung eingefügt wird. Dies geschieht dadurch, dass ein Rückkoppelpfad von dem Drainanschluss zu dem Gateanschluss eines LDMOS-Transistors eingefügt wird. Die Maßnahme gemäß Merkmal e) reduziert die von den Drains gesehene Impedanz bei hohen Frequenzen. Dadurch werden unerwünschte Resonanzen unterdrückt und das Ausfallsrisiko wegen zu hoher dV/dt reduziert.

Eine breitbandige Rückkopplung kann insbesondere dadurch erreicht werden, dass jeder Rückkoppelpfad eine Serienschaltung umfassend einen Widerstand und einem Kondensator aufweist. Dabei kann der Widerstand einen Widerstandswert im Bereich 200 bis 800 Ohm, insbesondere im Bereich 200 bis 600 Ohm, und der Kondensator eine Kapazität im Bereich 0,01 bis 5 nF, insbesondere im Bereich 0,5 bis 5 nF, aufweisen.

Alternativ oder zusätzlich kann vorgesehen sein, dass die Sekundärwicklung des Signalübertragers mit dem ersten Ende über ein oder mehrere resistive Elemente mit dem Gateanschluss des einen LDMOS-Transistors verbunden ist und mit dem zweiten Ende über ein oder mehrere resistive Elemente mit dem Gateanschluss des anderen LDMOS-Transistors verbunden ist. Durch das Vorsehen von resistiven Elementen wird eine "verlustbehaftete Gatebeschaltung" erzeugt. Dadurch können Instabilitäten, die durch eine Selbstschwingung entstehen, wirksam vermieden werden.

Insbesondere ist es ausreichend, resistive Elemente mit einem geringen Widerstandswert zu verwenden. Insbesondere können als resistive Elemente Widerstände mit einem Widerstandwert im Bereich zwischen 1 und 100 Ohm verwendet werden.

Die LDMOS-Transistoren sind für den Lawinenbetrieb optimiert. Ein Energieüberschuss, der durch Überspannung entsteht, wird in Wärme umgewandelt. So lange der Transistor dadurch nicht überhitzt wird, wird er nicht zerstört. Auch die Gate-Drain-Kapazität ist sehr gering und das Gate ist vom elektrischen Feld des Drains abgeschirmt. Dadurch ist auch das Risiko des schnellen Ausfalls durch Schalten des parasitären Bipolartransistors deutlich reduziert. Bei ungünstigen Lastbedingungen mit einem hohen Drainstrom wurden jedoch Ausfälle beim Verstärker für kleinere Frequenzen, von z.B. 13,56 MHz, beobachtet. Dies geschah, wenn Harmonische im Bereich von 300 bis 400 MHz einen hohen Anteil in der Drainspannung hatten. Eine Lösung besteht darin, das Ausgangsnetzwerk so zu entwerfen, dass es für diese Frequenzen niederohmig ist und keine hohe hochfrequente Drainspannung erzeugt wird. Gelingt dies jedoch nicht, ist es hilfreich, zur Stabilisierung Kapazitäten von den Drains zur Masse vorzusehen. Die Verbindung von den Drains zur Masse sollte dabei mit extrem geringer Anschlussinduktivität realisiert werden.

Eine geringe Anschlussinduktivität kann beispielsweise dadurch erreicht werden, dass die Kondensatoren über mehrere parallele Vias oder eine Durchkontaktierung in den Hitzeverteiler (Heatspreader) der LDMOS-Transistoren mit Masse verbunden sind. Wenn ein Hochfrequenzverstärker auf einer dünnen Leiterplatte aufgebaut ist, können die Verbindungen der Kondensatoren mit der Massefläche durch mehrere parallele Vias niederinduktiv realisiert werden. Bei einer mehrlagigen Leiterkarte ist dies jedoch schwierig. Hier kann die niederinduktive Anbindung im Wege einer Durchkontaktiereung in den Hitzeverteiler des Transistors erfolgen. Der Hitzeverteiler ist eine Metallplatte, die die Baugruppe der LDMOS-Transistoren aufweist. Dadurch kann von den Transistoren erzeugte Wärme über eine große Fläche verteilt werden.

Die Ausfallwahrscheinlichkeit der Hochfrequenzverstärkeranordnung kann weiterhin dadurch reduziert werden, wenn eine Leiterkarte vorgesehen ist, die flächig an einer metallischen Kühlplatte anliegt und die über mehrere Masseverbindungen mit der mit Masse verbindbaren Kühlplatte verbunden ist. Insbesondere kann die Baugruppe auf der Leiterkarte angeordnet sein. Somit kann Wärme besonders gut von der Baugruppe, die die LDMOS-Transistoren enthält, abgeführt werden. Ein Überhitzen der Transistoren kann dadurch weitestgehend vermieden werden.

In den Rahmen der Erfindung fällt weiterhin ein Verfahren zum Schutz einer erfindungsgemäße Hochfrequenzverstärkeranordnung, wobei die im Normalbetrieb als nicht lineare Verstärkeranordnung betriebene Hochfrequenzverstärkeranordnung bei einer Reduzierung der Sollleistung von mehr als 50 % im Linearbetrieb betrieben wird.

Eine Last mit einer hohen Güte speist einen Teil der gespeicherten Energie nach dem Ausschalten der Hochfrequenzverstärkeranordnung in den Verstärker zurück. Da die LDMOS-Transistoren in diesem Fall keinen oder nur einen sehr geringen Ruhestrom leiten, wird ein hochgütiger Schwingkreis, bestehend aus der Drainkapazität, einem Ausgangsnetzwerk und der Last gebildet. Hier besteht das Risiko, dass ein parasitärer Bipolartransistor geschaltet wird und die LDMOS-Transistoren dadurch zerstört werden. Die erfindungsgemäße Gegenmaßnahme sieht ein langsames Ausschalten der Hochfrequenzleistung vor. Dies kann dadurch erreicht werden, dass die Hochfrequenzverstärkeranordnung für eine bestimmte Zeit im Linearbetrieb betrieben wird.

Dabei kann die Hochfrequenzverstärkeranordnung über zumindest zwei Perioden der erzeugten Hochfrequenzleistung im Linearbetrieb betrieben werden. Die LDMOS-Transistoren arbeiten während dieser Zeit bei einer schlechten Effizienz. Dadurch kann die zurückgespeiste Leistung auf sichere Weise in Wärme umgewandelt werden.

Die Hochfrequenzverstärkeranordnung kann mindestens 100 ns in Linearbetrieb betrieben werden. Dadurch kann sichergestellt werden, dass ein Ausschalten ohne Zerstörung der Hochfrequenzverstärkeranordnung erfolgt.

Die Spannungspegel der Ansteuersignale für die Gates der LDMOS-Transistoren können im Normalbetrieb so gewählt werden, dass die Transistoren im eingeschalteten Zustand zumindest zweitweise im Sättigungsbetrieb betrieben werden. Im Linearbetrieb können die Spannungspegel der Ansteuersignale so gewählt werden, dass die Transistoren nicht im Sättigungsbetrieb betrieben werden. Somit kann über die Spannungspegel der Ansteuersignale eingestellt werden, ob die LDMOS-Transistoren im nicht linearen Verstärkerbetrieb oder im linearen Betrieb betrieben werden. Wenn beispielsweise der Hochfrequenzverstärker ausgeschaltet werden soll, also die Sollleistung auf Null sinkt, kann zunächst in einen linearen Betrieb übergegangen werden, um die Hochfrequenzverstärkeranordnung zu schützen.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen und aus den Ansprüchen. Die verschiedenen Merkmale können je einzeln für sich oder zu mehreren in beliebigen Kombinationen bei Varianten der Erfindung verwirklicht sein.

In der schematischen Zeichnung sind Ausführungsbeispiele der Erfindung dargestellt und in der nachfolgenden Beschreibung näher erläutert.

Es zeigen:
- Fig. 1: eine erfindungsgemäße Hochfrequenzverstärkeranordnung;
- Fig. 2a: Spannungsverläufe von Gatespannungen und Drainspannungen der LDMOS-Transistoren, wenn eine schnelle Reduzierung der Sollleistung erfolgt;
- Fig. 2b: entsprechende Spannungsverläufe, wenn eine schnelle Reduzierung der Sollleistung erfolgt, die Hochfrequenzverstärkeranordnung jedoch noch im Linearbetrieb betrieben wird;
- Fig. 3a: Diagramme, die erhalten werden, wenn keine Kondensatoren zwischen Drain und Masse verwendet werden;
- Fig. 3b: Diagramme, die erhalten werden, wenn Kondensatoren zwischen Drain und Masse verwendet werden.

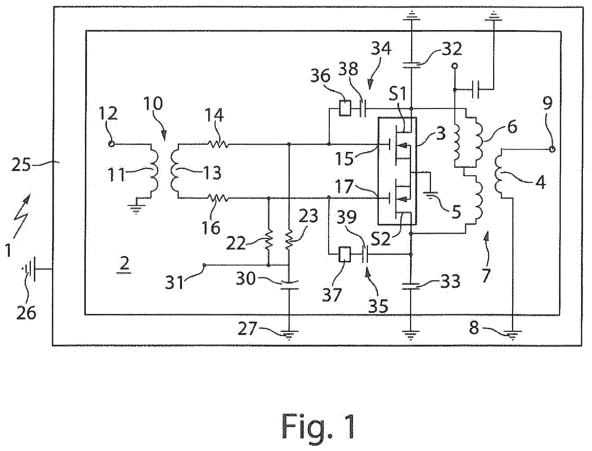

Die Figur 1 zeigt eine erste Ausführungsform einer Hochfrequenzverstärkeranordnung 1. Die Hochfrequenzverstärkeranordnung 1 umfasst eine Leiterkarte 2, auf der eine Baugruppe 3 angeordnet ist. Die Baugruppe 3 weist zwei LDMOS-Transistoren S1, S2 auf, die gleichartig ausgebildet sind und die mit ihrem Sourceanschluss jeweils mit einem Masseverbindungspunkt 5 verbunden sind.

Zur Stabilisierung der nichtlinear betreibbaren Hochfrequenzverstärkeranordnung sind Rückkoppelpfade 34, 35 von den Drainanschlüssen der LDMOS-Transistoren S1, S2 zu den Gateanschlüssen 15, 17 vorgesehen. Die Rückkoppelpfade 34, 35 weisen jeweils eine Serienschaltung umfassend einen Widerstand 36, 37 und einen Kondensator 38, 39 auf.

Mit ihren Drainanschlüssen sind die LDMOS-Transistoren S1, S2 jeweils mit einem Ende einer Primärwicklung 6 eines Leistungsübertragers 7, der Teil eines Ausgangsnetzwerks ist, verbunden. Die Sekundärwicklung 4 des Leistungsübertragers 7 ist zum einem mit Masse 8 und zum anderen mit einem Hochfrequenzausgang 9 verbunden.

Die Drainanschlüsse der LDMOS-Transistoren S1, S2 sind über jeweils einen Kondensator 32, 33 mit Masse verbunden. Diese Verbindung erfolgt über eine Durchkontaktierung in den Hitzeverteiler der LDMOS-Transistoren S1, S2.

Die Hochfrequenzverstärkeranordnung 1 weist weiterhin einen Signalübertrager 10 auf, der eine Primärwicklung 11 aufweist, die an einen Hochfrequenzeingang 12 angeschlossen ist. Die Sekundärwicklung 13 des Signalübertragers 10 ist zum einen über ein resistives Element 14, insbesondere einen Widerstand, mit dem Gateanschluss 15 des LDMOS-Transistors S1 verbunden. Zum anderen ist die Sekundärwicklung 13 über ein resistives Element 16, insbesondere einen Widerstand, mit dem Gateanschluss 17 des LDMOS-Transistors S2 verbunden. Die resistiven Elemente 14, 16 und die Sekundärwicklung 13 sind somit in Reihe geschaltet. Der Signalübertrager 10 ist ebenfalls auf der Leiterkarte 2 angeordnet, genauso wie der Leistungsübertrager 7.

Die Gateanschlüsse 15, 17 sind über Widerstände 22, 23 mit einem Kondensator 30 verbunden, der seinerseits mit Masse 27 verbunden ist. An den Anschluss 31 ist eine Gleichspannungsquelle angeschlossen.

Die Leiterkarte 2 liegt flächig auf einer Kühlplatte 25 auf, die ebenfalls mit Masse 26 verbindbar ist. Insbesondere ist die Leiterkarte 2 über mehrere Masseverbindungen 8, 27 mit der Kühlplatte 25 verbunden. Die Masseverbindung 5 stellt einen Masseverbindungspunkt zur Wärmeübertragung von LDMOS-Transistoren S1, S2 zur Kühlplatte 25 dar.

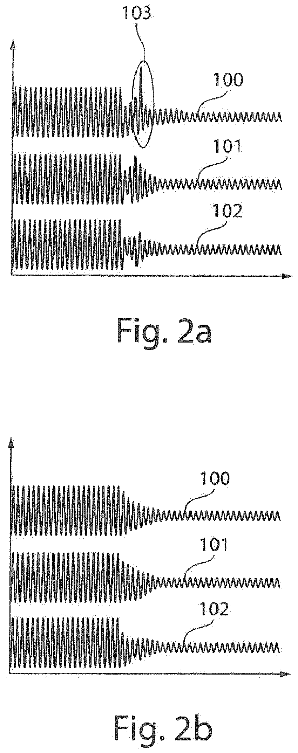

Die Figur 2a zeigt den Drainspannungsverlauf 100 des ersten LDMOS-Transistors S1 und den Drainspannungsverlauf 101 des zweiten LDMOS-Transistors S2. Mit der Bezugsziffer 102 ist die Gatespannung, mit der die LDMOS-Transistoren angesteuert werden, gezeigt. Durch die Markierung 103 sind Spannungsspitzen markiert, die in der Drainspannung auftreten, wenn die Sollleistung abrupt reduziert wird, insbesondere die Hochfrequenzverstärkeranordnung ausgeschaltet wird, ohne dass anschließend zum Abschalten in einen linearen Verstärkerbetrieb gewechselt wird. Diese Spannungsspitzen gilt es, zu vermeiden.

Die Figur 2b zeigt die entsprechenden Spannungen 100, 101, 102, wenn bei der plötzlichen Reduzierung der Sollleistung von einem nicht linearen Verstärkerbetrieb in einen linearen Verstärkerbetrieb übergegangen wird. Hier ist zu erkennen, dass die Spannungsspitzen in den Drainspannungen 100, 101 nicht entstehen, wodurch die LDMOS-Transistoren geschützt werden.

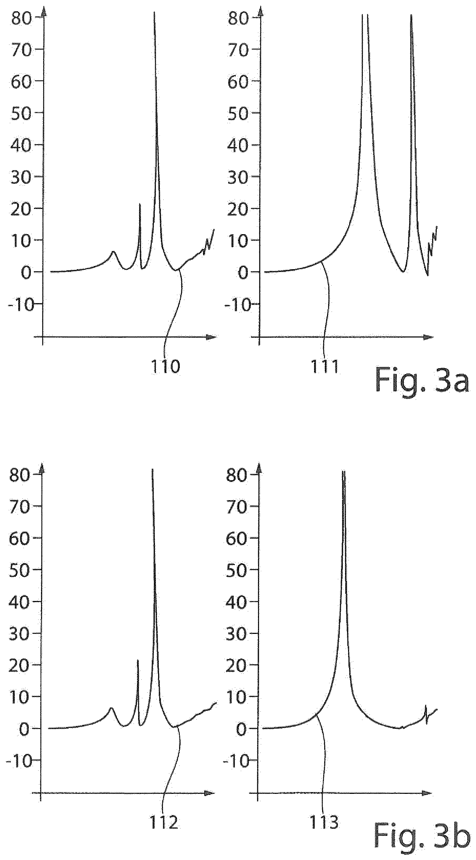

Die Figur 3a zeigt links die "Differential-Mode"-Impedanz 110 und rechts die "Commmon-Mode"- Impedanz 111 des Anpassnetzwerks (von den Drains gesehen), wenn keine Kondensatoren zwischen Drain und Masse vorgesehen werden.

In der Figur 3b links die "Differential-Mode"-Impedanz 112 und rechts die "Commmon-Mode"- Impedanz 113 des Anpassnetzwerks (von den Drains gesehen), wenn entsprechende Kondensatoren 32, 33 eingesetzt werden.

## Patentansprüche

1. Nicht lineare Hochfrequenzverstärkeranordnung (1), die geeignet ist, Ausgangsleistungen ≥ 1kW bei Frequenzen ≥ 1MHz zur Plasmaanregung zu erzeugen, umfassend:
a. zwei LDMOS-Transistoren (S1, S2), die mit ihrem Sourceanschluss jeweils mit einem Masseverbindungspunkt (5) verbunden sind, wobei die LDMOS-Transistoren (S1, S2) gleichartig ausgebildet sind und in einer Baugruppe (Package) (3) angeordnet sind,
b. einen Leistungsübertrager (7), dessen Primärwicklung (6) mit den Drainanschlüssen der LDMOS-Transistoren (S1, S2) verbunden ist,
c. einen Signalübertrager (11), dessen Sekundärwicklung (13) mit einem ersten Ende mit dem Gateanschluss (15) des einen LDMOS-Transistors (S1) und mit einem zweiten Ende mit dem Gateanschluss (17) des anderen LDMOS-Transistors (S2), insbesondere über einen Widerstand, verbunden ist, **gekennzeichnet durch**
d. jeweils einen Rückkoppelpfad (34, 35) von dem Drainanschluss zu dem Gateanschluss (15, 17) jedes LDMOS-Transistors (S1, S2) und wobei
e. die Drainanschlüsse der LDMOS-Transistoren (S1, S2) jeweils über zumindest einen Kondensator (32, 33) mit Masse verbunden sind.

2. Hochfrequenzverstärkeranordnung nach Anspruch 1, **dadurch gekennzeichnet, dass** jeder Rückkoppelpfad (34, 35) eine Serienschaltung umfassend einen Widerstand (36, 37) und einen Kondensator (38, 39) aufweist.

3. Hochfrequenzverstärkeranordnung nach Anspruch 2, **dadurch gekennzeichnet, dass** der Widerstand (36, 37) einen Widerstandswert im Bereich 200 - 600 Ohm und der Kondensator (38, 39) eine Kapazität im Bereich 0,5 - 5nF aufweist.

4. Hochfrequenzverstärkeranordnung nach einem der vorhergehenden Ansprüche, **dadurch gekennzeichnet, dass** die Sekundärwicklung (13) des Signalübertragers (11) mit dem ersten Ende über ein oder mehrere resistive Elemente (14) mit dem Gateanschluss (15) des einen LDMOS-Transistors (S1) verbunden ist und mit dem zweiten Ende über ein oder mehrere resistive Elemente (16) mit dem Gateanschluss (17) des anderen LDMOS-Transistors (S2) verbunden ist, so dass eine verlustbehaftete Gateschaltung erzeugt wird.

5. Hochfrequenzverstärkeranordnung nach Anspruch 4, **dadurch gekennzeichnet, dass** die resistiven Elemente (14, 16) als Widerstände mit einem Widerstandswert im Bereich zwischen 1 und 100 Ohm ausgebildet sind.

6. Hochfrequenzverstärkeranordnung nach einem der vorhergehenden Ansprüche, **dadurch gekennzeichnet, dass** die Gateanschlüsse (15, 17) über Widerstände (22, 23) mit einem weiteren Kondensator (30) verbunden sind, der seinerseits mit Masse (27) verbunden ist.

7. Hochfrequenzverstärkeranordnung nach einem der vorhergehenden Ansprüche, **dadurch gekennzeichnet, dass** die Kondensatoren (32, 33) über mehrere parallele Vias oder eine Durchkontaktierung in den Hitzeverteiler der LDMOS-Transistoren (S1, S2) mit Masse verbunden sind.

8. Hochfrequenzverstärkeranordnung nach einem der vorhergehenden Ansprüche, **dadurch gekennzeichnet, dass** eine Leiterkarte (2) vorgesehen ist, die flächig an einer metallischen Kühlplatte (25) anliegt und über mehrere Masseverbindungen (8, 27) mit der mit Masse (26) verbindbaren Kühlplatte (25) verbunden ist.

9. Hochfrequenzverstärkeranordnung nach Anspruch 8, **dadurch gekennzeichnet, dass** die Baugruppe (3) auf der Leiterkarte (2) angeordnet ist.

10. Verfahren zum Schutz einer Hochfrequenzverstärkeranordnung nach einem der vorhergehenden Ansprüche, **dadurch gekennzeichnet, dass** die im Normalbetrieb als nicht lineare Verstärkeranordnung betriebene Hochfrequenzverstärkeranordnung bei einer Reduzierung der Sollleistung von mehr als 50% im Linearbetrieb betrieben wird.

11. Verfahren nach Anspruch 10, **dadurch gekennzeichnet, dass** die Hochfrequenzverstärkeranordnung über zumindest 2 Perioden der erzeugten Hochfrequenzleistung im Linearbetrieb betrieben wird.

12. Verfahren nach Anspruch 10 oder 11, **dadurch gekennzeichnet, dass** die Hochfrequenzverstärkeranordnung für mindestens 100ns im Linearbetrieb betrieben wird.

13. Verfahren nach einem der Ansprüche 10 - 12, **dadurch gekennzeichnet, dass** die Gates der LDMOS-Transistoren (S1, S2) im Normalbetrieb die Spannungspegel der Ansteuersignale so gewählt werden, dass die Transistoren (S1, S2) im eingeschalteten Zustand zumindest zeitweise im Sättigungsbetrieb betrieben werden, und im Linearbetrieb die Spannungspegel der Ansteuersignale so gewählt werden dass die Transistoren (S1, S2) nicht im Sättigungsbetrieb betrieben werden

## Claims

1. A non-linear high-frequency amplifier arrangement (1) that is suitable for generating output powers ≥ 1 kW at frequencies ≥ 1 MHz for plasma excitation, comprising:
a. two LDMOS transistors (S1, S2), the source terminal of each of which is connected to a ground connection point (5), wherein the LDMOS transistors (S1, S2) are of equal design and arranged in an assembly (package) (3),
b. a power transformer (7), the primary winding (6) of which is connected to the drain terminals of the LDMOS transistors (S1, S2),
c. a signal transformer (11), the secondary winding (13) of which is connected, by a first end, to the gate terminal (15) of one LDMOS transistor (S1) and, by a second end, to the gate terminal (17) of the other LDMOS transistor (S2), in particular via a resistor, **characterised by**
d. respective feedback paths (34, 35) from the drain terminal to the gate terminal (15, 17) of each LDMOS transistor (S1, S2), and wherein
e. the drain terminals of the LDMOS transistors (S1, S2) are each connected to ground via at least one capacitor (32, 33).

2. The high-frequency amplifier arrangement according to claim 1, **characterised in that** each feedback path (34, 35) has a series circuit comprising a resistor (36, 37) and a capacitor (38, 39).

3. The high-frequency amplifier arrangement according to claim 2, **characterised in that** the resistor (36, 37) has a resistance value in the range of 200-600 ohms and the capacitor (38, 39) has a capacitance in the range of 0.5-5 nF.

4. The high-frequency amplifier arrangement according to any one of the preceding claims, **characterised in that** the secondary winding (13) of the signal transformer (11) is connected, by the first end, via one or more resistive elements (14), to the gate terminal (15) of one LDMOS transistor (S1) and is connected, by the second end, via one or more resistive elements (16), to the gate terminal (17) of the other LDMOS transistor (S2) so that a lossy gate circuit is generated.

5. The high-frequency amplifier arrangement according to claim 4, **characterised in that** the resistive elements (14, 16) are formed as resistors having a resistance value in the range between 1 and 100 ohms.

6. The high-frequency amplifier arrangement according to any one of the preceding claims, **characterised in that** the gate terminals (15, 17) are connected, via resistors (22, 23), to a further capacitor (30), which in turn is connected to ground (27).

7. The high-frequency amplifier arrangement according to any one of the preceding claims, **characterised in that** the capacitors (32, 33) are connected to ground via a plurality of parallel vias or a through-connection into the heat distributor of the LDMOS transistors (S1, S2).

8. The high-frequency amplifier arrangement according to any one of the preceding claims, **characterised in that** a printed circuit board (2) is provided, lying flat against a metal cooling plate (25) and connected to the cooling plate (25), which is connectable to ground (26), via a plurality of ground connections (8, 27).

9. The high-frequency amplifier arrangement according to claim 8, **characterised in that** the assembly (3) is arranged on the printed circuit board (2).

10. A method for protecting a high-frequency amplifier arrangement according to any one of the preceding claims, **characterised in that** the high-frequency amplifier arrangement, which is operated as a non-linear amplifier arrangement in normal operation, is operated in linear operation in the event of a reduction in the nominal power by more than 50%.

11. The method according to claim 10, **characterised in that** the high-frequency amplifier arrangement is operated in linear operation over at least two periods of the generated high-frequency power.

12. The method according to claim 10 or 11, **characterised in that** the high-frequency amplifier arrangement is operated in linear operation for at least 100 ns.

13. The method according to any one of claims 10-12, **characterised in that**, in normal operation, for the gates of the LDMOS transistors (S1, S2) the voltage levels of the control signals are selected such that the transistors (S1, S2), when switched on, are operated at least temporarily in saturation mode and, in linear operation, the voltage levels of the control signals are selected such that the transistors (S1, S2) are not operated in saturation mode.

## Revendications

1. Ensemble amplificateur haute fréquence (1) non linéaire, lequel est conçu pour générer des puissances de sortie ≥ 1 kW à des fréquences ≥ 1 MHz pour l'excitation du plasma, comprenant :
a. deux transistors LDMOS (S1, S2), lesquels sont respectivement reliés à une borne de mise à la masse (5) par l'intermédiaire de leur broche source, dans lequel les transistors LDMOS (S1, S2) sont conçus de manière similaire et disposés dans un module (boîtier) (3),
b. un groupe de transfert de puissance (7) dont un enroulement primaire (6) est raccordé aux broches drain des transistors LDMOS (S1, S2),
c. un groupe de transfert de signaux (11), dont un enroulement secondaire (13) est raccordé par une première extrémité à une broche grille (15) de l'un des transistors LDMOS (S1) et par une seconde extrémité à une broche grille (17) de l'autre transistor LDMOS (S2), en particulier par l'intermédiaire d'une résistance, **caractérisé par**
d. un chemin de rétroaction (34, 35) respectif de la broche drain à broche grille (15, 17) du transistor LDMOS (S1, S2) respectif, et dans lequel
e. les broches drain des transistors LDMOS (S1, S2) sont respectivement mises à la masse par l'intermédiaire d'au moins un condensateur (32, 33).

2. Ensemble amplificateur haute fréquence selon la revendication 1, **caractérisé en ce que** le chemin de rétroaction (34, 35) respectif comporte un circuit série comprenant une résistance (36, 37) et un condensateur (38, 39).

3. Ensemble amplificateur haute fréquence selon la revendication 2, **caractérisé en ce que** la résistance (36, 37) présente une valeur de résistance dans la plage comprise entre 200 et 600 ohms et le condensateur (38, 39) présente une capacité dans la plage comprise entre 0,5 et 5 nF.

4. Ensemble amplificateur haute fréquence selon l'une quelconque des revendications précédentes, **caractérisé en ce que** l'enroulement secondaire (13) du groupe de transfert de signaux (11) est relié à la broche grille (15) de l'un des transistors LDMOS (S1) par la première extrémité, au moyen d'au moins un élément résistif (14), et, par la seconde extrémité, à la broche grille (17) de l'autre transistor LDMOS (S2) au moyen d'au moins un élément résistif (16), de telle sorte qu'un circuit de grille à pertes est généré.

5. Ensemble amplificateur haute fréquence selon la revendication 4, **caractérisé en ce que** les éléments résistifs (14, 16) sont conçus sous la forme de résistances présentant une valeur de résistance dans la plage comprise entre 1 et 100 ohms.

6. Ensemble amplificateur haute fréquence selon l'une quelconque des revendications précédentes, **caractérisé en ce que** les broches grille (15, 17) sont reliées par l'intermédiaire des résistances (22, 23), à un autre condensateur (30), lequel de son côté est mis à la masse (27).

7. Ensemble amplificateur haute fréquence selon l'une quelconque des revendications précédentes, **caractérisé en ce que** les condensateurs (32, 33) sont mis à la masse par l'intermédiaire de plusieurs vias parallèles ou d'un contact traversant dans le diffuseur de chaleur des transistors LDMOS (S1, S2).

8. Ensemble amplificateur haute fréquence selon l'une quelconque des revendications précédentes, **caractérisé en ce qu'**une carte de circuit imprimé (2) est prévue, laquelle repose à plat sur une plaque de refroidissement (25) métallique et laquelle est reliée, à l'aide de plusieurs bornes de mise à la masse (8, 27), à la plaque de refroidissement (25), laquelle peut être mise à la masse (26).

9. Ensemble amplificateur haute fréquence selon la revendication 8, **caractérisé en ce que** le module (3) est disposé sur la carte de circuit imprimé (2).

10. Procédé de protection d'un ensemble amplificateur haute fréquence selon l'une quelconque des revendications précédentes, **caractérisé en ce que** l'ensemble amplificateur haute fréquence, fonctionnant en fonctionnement normal comme un amplificateur non linéaire, fonctionne de manière linéaire lors d'une réduction de la puissance nominale de plus de 50 %.

11. Procédé selon la revendication 10, **caractérisé en ce que** l'ensemble amplificateur haute fréquence fonctionne de manière linéaire sur au moins 2 périodes de la puissance haute fréquence générée.

12. Procédé selon la revendication 10 ou 11, **caractérisé en ce que** l'ensemble amplificateur haute fréquence fonctionne de manière linéaire pendant au moins 100 ns.

13. Procédé selon l'une quelconque des revendications 10 à 12, **caractérisé en ce que**, en fonctionnement normal, pour les grilles des transistors LDMOS (S1, S2) les niveaux de tension des signaux de commande sont sélectionnés de telle sorte que les transistors (S1, S2), en état enclenché, fonctionnent au moins temporairement en fonctionnement en saturation et, en fonctionnement linéaire, les niveaux de tension des signaux de commande sont sélectionnés de telle sorte que les transistors (S1, S2) ne fonctionnent pas en fonctionnement en saturation.
